**Europäisches Patentamt**

**European Patent Office**

**Office européen des brevets**

(19)

(11) Numéro de publication: **0 120 721 B1**

(12) **FASCICULE DE BREVET EUROPEEN**

(45) Date de publication du fascicule du brevet:
**13.05.87**

(51) Int. Cl.⁴: **G 11 C 8/00,** H 04 M 7/04

(21) Numéro de dépôt: **84400165.1**

(22) Date de dépôt: **25.01.84**

(54) **Mémoire de mots munie d'un circuit de transcodage d'adresses.**

(30) Priorité: **01.02.83 FR 8301544**

(43) Date de publication de la demande:
**03.10.84 Bulletin 84/40**

(45) Mention de la délivrance du brevet:
**13.05.87 Bulletin 87/20**

(84) Etats contractants désignés:
**CH DE GB IT LI NL SE**

(56) Documents cités:
**PATENTS ABSTRACTS OF JAPAN, vol. 4, no. 5, 16
janvier 1980, page 74E165;
PATENTS ABSTRACTS OF JAPAN, vol. 1, no. 153, 8
décembre 1977, page 8187E77;**

(73) Titulaire: **Brion, Alain, 15, rue Kermen, F-92140 Clamart
(FR)**

(72) Inventeur: **Brion, Alain, 15, rue Kermen, F-92140 Clamart
(FR)**

(74) Mandataire: **Mongrédien, André et al, c/o
BREVATOME 25, rue de Ponthieu, F-75008 Paris (FR)**

ACTORUM AG

## Description

La présente invention a pour objet une mémoire de mots munie d'un circuit de transcodage d'adresses.

Les mémoires courantes sont organisées en mots constitués de plusieurs éléments binaires. Le nombre de mots est en général une puissance de deux. Comme on a souvent besoin de mémoires ayant une forme matricielle, la répartition de ces mots correspond à des matrices de $2^p$ par $2^q$ mots. Dans ce cas, pour écrire ou lire un mot dans la mémoire, il suffit d'afficher une adresse colonne X sur un premier groupe de p fils d'adresse et une adresse ligne Y sur un second groupe de q fils d'adresse.

Cependant, il est souhaitable parfois de disposer d'une mémoire de A×B mots où les nombres A et B ne sont pas des puissances de 2. C'est le cas notamment avec les mémoires d'écran alphanumérique où l'on a besoin de 80×24 caractères (ou de 80×25) ou avec les mémoires d'écran graphique au format facsimilé à 1728×2288 points dans laquelle les points sont groupés par mots de 64 éléments binaires, ce qui conduit à des mémoires de 27×2288 mots.

Lorsque A et B ne sont pas des puissances de 2, on peut écrire:

$$2^p < A < 2^{p+1}$$
$$2^q < B < 2^{q+1} \tag{1}$$

inégalités où p et q sont les exposants des plus proches puissances de 2 inférieures à A et à B.

En d'autres termes, cela signifie que A s'exprime avec p+1 éléments binaires, et B avec q+1 éléments binaires.

Deux cas peuvent se présenter:

$$\text{si } 2^{p+q+1} < A \times B < 2^{p+q+2} \tag{2}$$

on est obligé d'utiliser une mémoire de $2^{p+q+2}$ mots; il suffit alors de majorer A et B respectivement par $2^{p+1}$ et $2^{q+1}$.

$$\text{si } 2^{p+q} < A \times B < 2^{p+q+1} \tag{3}$$

on pourrait encore prendre une mémoire de $2^{p+q+2}$ mots, mais elle serait mal utilisée puisque toute la moitié allant de $2^{p+q+1}$ à $2^{p+q+2}$ serait inemployée.

Le problème que se propose de résoudre l'invention est justement de trouver un moyen permettant d'utiliser une mémoire de capacité $2^{p+q+1}$ mots, dans le cas particulier où chaque mot est défini par une première adresse à p+1 éléments binaires et une deuxième adresse à q+1 éléments binaires.

L'invention résout ce problème par l'adjonction d'un circuit de transcodage d'adresses à p+q+2 entrées et à p+q+1 sorties. Ce circuit comprend deux parties:

a) une première partie constituée par:

p+1 entrées et p+1 sorties, les p+1 entrées recevant p+1 éléments binaires définissant un nombre X inférieur à A, ces éléments binaires étant répartis entre un élément de plus faible poids et un élément de plus fort poids, les p+1 sorties étant reliées à p+1 premières entrées d'adressage de la mémoire,

p+1−r connexions directes entre les p+1−r entrées affectées aux p+1−r éléments binaires de plus faible poids et p+1−r sorties,

un premier multiplexeur possédant un premier groupe de r entrées recevant des expressions logiques des r éléments binaires de plus fort poids de X reçus par les r entrées correspondantes, et possédant un second groupe de r entrées portées à un même niveau logique prédéterminé, ce premier multiplexeur possédant r sorties reliées aux r sorties restantes de cette première partie,

b) une seconde partie constituée par:

q+1 entrées et q sorties, les q+1 entrées recevant q+1 éléments binaires définissant un nombre Y inférieur à B, ces éléments binaires étant répartis entre un élément binaire de plus faible poids et un élément binaire de plus fort poids, les q sorties étant reliées aux q dernières entrées d'adressage de la mémoire,

q−r connexions directes entre les q−r entrées affectées aux q−r éléments binaires de plus faible poids de Y et q−r sorties,

un second multiplexeur possédant un premier groupe de r entrées recevant des expressions logiques de r éléments binaires de plus fort poids de Y pris après l'élément binaire de Y ayant le plus fort poids et possédant un second groupe de r entrées reliées au premier groupe de r entrées du premier multiplexeur de la première partie, ce second multiplexeur possédant r sorties reliées aux r sorties restantes de cette seconde partie,

chaque multiplexeur possédant en outre une entrée de commande qui reçoit l'élément binaire de plus fort poids du nombre Y appliqué à l'entrée de plus fort poids de la second partie.

Dans ce qui précède, r est un entier vérifiant les relations:

$$(2^r-1)\, 2^{p+1-r} \geqslant A$$
$$2^q + 2^{q-r} \geqslant B \tag{4}$$

Grâce à ce circuit de transcodage, les r entrées d'adressage de la mémoire, qui sont reliées aux sorties du premier multiplexeur reçoivent, selon la valeur de l'élément binaire de plus fort poids de Y, soit r expressions logiques de r éléments binaires de plus fort poids de X, soit r niveaux logiques prédéterminés; les r entrées d'adressage de la mémoire qui sont reliées aux sorties du second multiplexeur reçoivent de même, soit les r éléments binaires de plus fort poids de Y pris après l'élément ayant le plus fort poids, soit les r éléments binaires de plus fort poids de X. Il y a donc multiplexage d'adresses sur deux groupes de r entrées d'adressage.

Les caractéristiques de l'invention apparaîtront mieux après la description qui suit, d'exemples de réalisation donnés à titre explicatif et nullement limitatif. Cette description se réfère à des dessins annexés sur lesquels:

la fig. 1 est un diagramme montrant la place respective des nombres A et B par rapport aux puissances de 2;

la fig. 2 est un schéma général d'une mémoire conforme à l'invention;

la fig. 3 illustre un mode particulier de réalisation d'une mémoire de 24×80 mots utilisant une mémoire de 2048 mots;

la fig. 4 illustre un autre mode particulier de réalisation d'une mémoire de 27×2288 mots utilisant une mémoire de 64K mots.

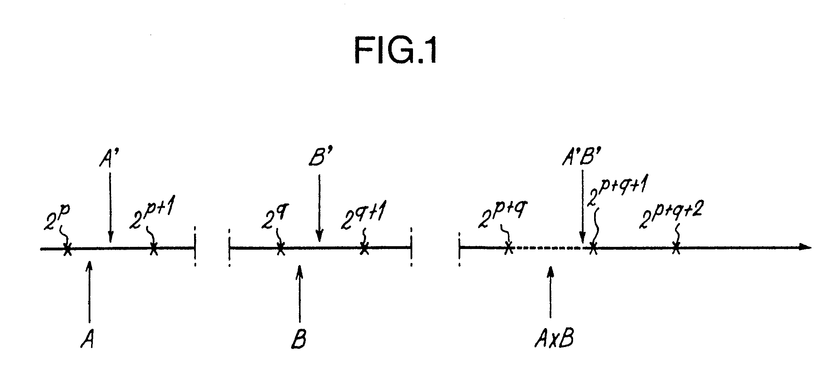

La fig. 1 est un diagramme qui permet de préciser graphiquement les places relatives de nombres A et B et du produit AB. Ce dernier est supposé compris entre $2^{p+q}$ et $2^{p+q+1}$ et non entre $2^{p+q+1}$ et $2^{p+q+2}$ auquel cas, il n'y aurait pas d'autres moyens que d'utiliser une mémoire de capacité $2^{p+q+2}$. Le domaine d'application de l'invention correspond donc à la zone hachurée de l'axe.

L'idée qui est à la base de l'invention est de multiplexer certaines adresses pour réduire de $p+q+2$ à $p+q+1$ le nombre d'entrées d'adressage. Ce multiplexage est possible, en faisant intervenir judicieusement deux groupes de r adresses, le nombre r étant défini à partir de deux nombres A′ et B′ supérieurs ou égaux à A et B, respectivement:

$$A' = 2^{p+1-r} \cdot (2^r -) \geqslant A$$
$$B' = 2^{q-r} \cdot (2^r \times 1) \geqslant B \tag{4}$$

Le nombre A′ étant égal à $2^{p+1}-2^{p+1-r}$, il est donc inférieur à $2^{p+1}$. Le nombre B′ étant égal à $2^q+2^{q-r}$, il est donc inférieur à $2^q+2^q$ donc à $2^{q+1}$. Le produit A′B′ est égal à $2^{p+q+1}-2^{p+q+1-2r}$. Il est donc compris entre AB et $2^{p+q+1}$. Autrement dit, une mémoire de A′B′ mots tombe bien dans le domaine de l'invention et présente une capacité supérieure à AB.

Les places respectives de A′, B′ et de A′B′ sont marquées sur le diagramme de la fig. 1.

Le point A′B′ est bien dans la zone hachurée.

Au lieu de réaliser une mémoire de AB mots on va réaliser une mémoire de A′B′ mots en utilisant la forme particulière du produit A′B′.

Lorsque l'élément binaire de plus fort poids de Y est à 1, ce qui donne à Y au moins la valeur $2^q$, tous les éléments binaires de Y de poids supérieur à q–r nécessairement nuls sinon B′ excéderait $2^q+2^{q-r}$. Ceci permet de multiplexer les adresses de la manière suivante:

—p+1–r éléments d'adressage vont recevoir en permanence les p+1–r éléments binaires de poids faible du nombre X inférieur à A,

—q–r entrées d'adressage vont recevoir en permanences les q–r éléments binaires de poids faible du nombre Y inférieur à B,

—r entrées d'adressage vont recevoir:
— soit les r éléments binaires de poids fort de X quand l'élément binaire de poids fort de Y est à «0»,
— soit «1» (c'est-à-dire un niveau logique prédéterminé) quand l'élément binaire de poids fort de Y est à «1».

—r autres entrées d'adressage vont recevoir:

— soit les r éléments binaires de poids fort de Y (sauf son élément binaire de plus fort poids) quand l'élément binaire de poids fort de Y est à «0»,
— soit les r éléments binaires de poids fort de X quand l'élément binaire de poids fort de Y est à «1».

Pour préciser ces questions, on notera Xo...Xp les p+1 éléments binaires de X (Xo désignant l'élément binaire de plus faible poids et Xp l'élément binaire de plus fort poids); on notera de même Yo...Yq les q+1 éléments binaires de Y (Yo étant l'élément binaire de plus faible poids et Yq l'élément binaire de plus fort poids); enfin, on notera Mo...Mp+q les p+q+1 entrées d'adressage de la mémoire.

On peut alors écrire la correspondante entre les entrées d'adressage et les éléments binaires d'adressage de la manière suivante:

$$
\begin{array}{cccc}
\overbrace{\phantom{xxx}}^{r} & \overbrace{\phantom{xxx}}^{q-r} & \overbrace{\phantom{xxx}}^{r} & \overbrace{\phantom{xxx}}^{p+1-r} \\
\end{array}
$$

sur: $\overline{\text{Mp+q...M}}$  $\overbrace{\text{M...M}}$  $\overbrace{\text{M...M}}$  $\overbrace{\text{M...Mo}}$

Si Yq=0 on trouve  Yq–1...Yq–r  Yq–r–1...Yo  Xp...Xp+1–r  Xp–r...Xo

Si Yq=1 on trouve  Xp...Xp+1–r  Yq–r–1...Yo  ↑...↑  «1»...«1»  Xp–r...Xo  ↑...↑

Les entrées multiplexées sont marquées par des flèches.

Pour trouver l'entier r, on part des inégalités (4) et on cherche la plus petite puissance de 2 supérieure à $B-2^q$, ce qui va donner $2^{q-r}$. On en déduit la plus grande valeur de r possible et on vérifie si cette valeur satisfait la première inéquation des inégalités (4), relative à A, à savoir $(2^r-1) \cdot 2^{p+1-r} \geqslant A$.

Si r existe, il peut y avoir plusieurs valeurs convenant. Dans ce cas, on choisit de préférence la plus petite.

Si r n'existe pas, on renouvelle l'essai en permutant A et B.

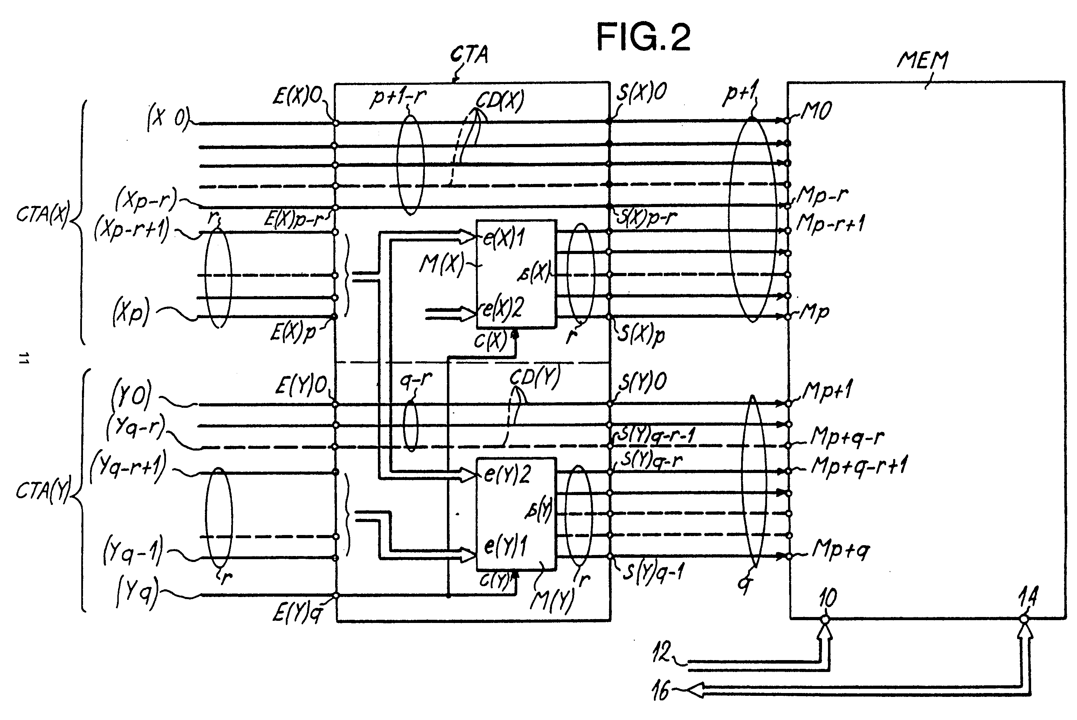

D'un point de vue concret, une mémoire conçue selon l'invention se présente sous la forme illustrée sur la fig. 2. La mémoire proprement dite, MEM, comprend p+q+1 entrées d'adressage notées Mo à Mp+q. Elle est précédée d'un circuit de transcodage d'adresses CTA, comprenant deux parties, respectivement CTA(X) et CTA(Y), chargées de traiter les nombres X et Y qui constituent les adresses du mot à désigner parmi les A×B mots possibles.

La première partie CTA(X) est constituée par:

— p+1 entrées notées E(X)o...E(X)p et p+1 sorties notées S(X)o...S(X)p; les p+1 entrées reçoivent les p+1 éléments binaires Xo, X1...Xp défainissant le nombre X. Ces éléments binaires sont répartis entre un élément de plus faible poids, Xo, et un élément de plus fort poids; les p+1 sorties sont reliées à p+1 premières entrées d'adressage de la mémoire, soit Mo à Mp.

— p+1–r connexions directes CD(X) entre les p+1–r entrées E(X)o...E(X)p–r affectées aux

$p+1-r$ éléments binaires de plus faible poids $Xo...Xp-r$ et $p+1-r$ sorties $S(X)o...S(X)p-r$.

– un premier multiplexeur $M(X)$ possédant un premier groupe $e(X)1$ de $r$ entrées recevant des expressions logiques de $r$ éléments binaires de plus fort poids de $X$ ($Xp-r+1...Xp$) reçus par les $r$ entrées correspondantes $E(X)p-r+1...E(X)p$; le multiplexeur possède un second groupe $e(X)2$ de $r$ entrées portées à un même niveau logique prédéterminé, par exemple à 1; ce premier multiplexeur possède enfin $r$ sorties $s(X)$ reliées aux $r$ sorties restantes, $S(X)p-r+1...S(X)p$.

La seconde partie, $CTA(Y)$, du circuit de transcodage est constituée par:

– $q+1$ entrées notées $E(Y)o...E(Y)q$ et $q$ sorties notées $S(Y)o...X(Y)q-1$; les $q+1$ entrées reçoivent $q+1$ éléments binaires, soit $Yo, Y1...Yq$, définissant le nombre $Y$; ces éléments binaires sont répartis entre un élément de plus faible poids, $Yo$, et un élément de plus fort poids $Yq$; les $q$ sorties $S(Y)o...S(Y)q-1$ sont reliées aux $q$ dernières entrées d'adressage de la mémoire, soit $Mp+1...Mp+q$.

– $q-r$ connexions directes $CD(Y)$ entre les $q-r$ entrées $E(Y)o...E(Y)q-r$ affectées aux $q-r$ éléments binaires de plus faible poids de $Y$ et $q-r$ sorties $S(Y)o...S(Y)q-r-1$,

– un second multiplexeur $M(Y)$ possédant un premier groupe $e(X)1$ de $r$ entrées recevant des expressions logiques des $r$ éléments binaires $Yq-r...Yq-1$ de plus fort poids de $Y$ pris après l'élément binaire $Yq$ de plus fort poids, et un second groupe $e(Y)2$ de $r$ entrées reliées au premier groupe de $r$ entrées du premier multiplexeur de la première partie, ce second multiplexeur possédant $r$ sorties $s(Y)$ reliées aux $r$ sorties restantes de cette seconde partie, soit $S(Y)q-r...S(Y)q-1$.

Chaque multiplexeur $M(X)$, $M(Y)$ possède en outre une entrée de commande, respectivement $C(X)$, $C(Y)$, qui reçoit une expression logique de l'élément binaire de plus fort poids du nombre $Y$ soit $Yq$, appliqué à l'entrée de plus fort poids $E(Y)q$ de la seconde partie.

Les $r$ entrées d'adressage $Mp-r+1...Mp$ de la mémoire qui sont reliées aux sorties du premier multiplexeur $M(X)$ reçoivent ainsi, selon la valeur de l'élément binaire $Yq$ de plus fort poids de $Y$, $r$ expressions logiques des $r$ éléments binaires de plus fort poids de $X$, soit $r$ niveaux logiques prédéterminés. De même, les $r$ entrées d'adressage $Mp+q-r...Mp+q$ de la mémoire, qui sont reliées aux sorties du second multiplexeur, reçoivent soit les $r$ éléments binaires de plus fort poids de $Y$ pris après $Yq$, soit les $r$ éléments binaires de plus fort poids de $X$.

En plus de ses entrées d'adressage, la mémoire MEM comprend naturellement une entrée de commande 10 reliée à un bus de commande 12 et une entrée de données 14 reliée à un bus de données 16.

Dans la description qui précède, les entrées des multiplexeurs reçoivent certains éléments binaires mais elles pourraient évidemment recevoir leur complément. Dans ce cas, il suffirait d'adjoindre, dans le circuit représenté, un inverseur logique entre l'entrée du circuit de transcodage et l'entrée du multiplexeur. Dans les exemples qui vont suivre, on supposera que les entrées des multiplexeurs reçoivent les éléments binaires eux-mêmes.

En pratique, chaque multiplexeur peut être constitué de $r$ multiplexeurs élémentaires à deux entrées et une sortie. On peut utiliser par exemple le multiplexeur 74-LS 158 de la Société Texas Instruments.

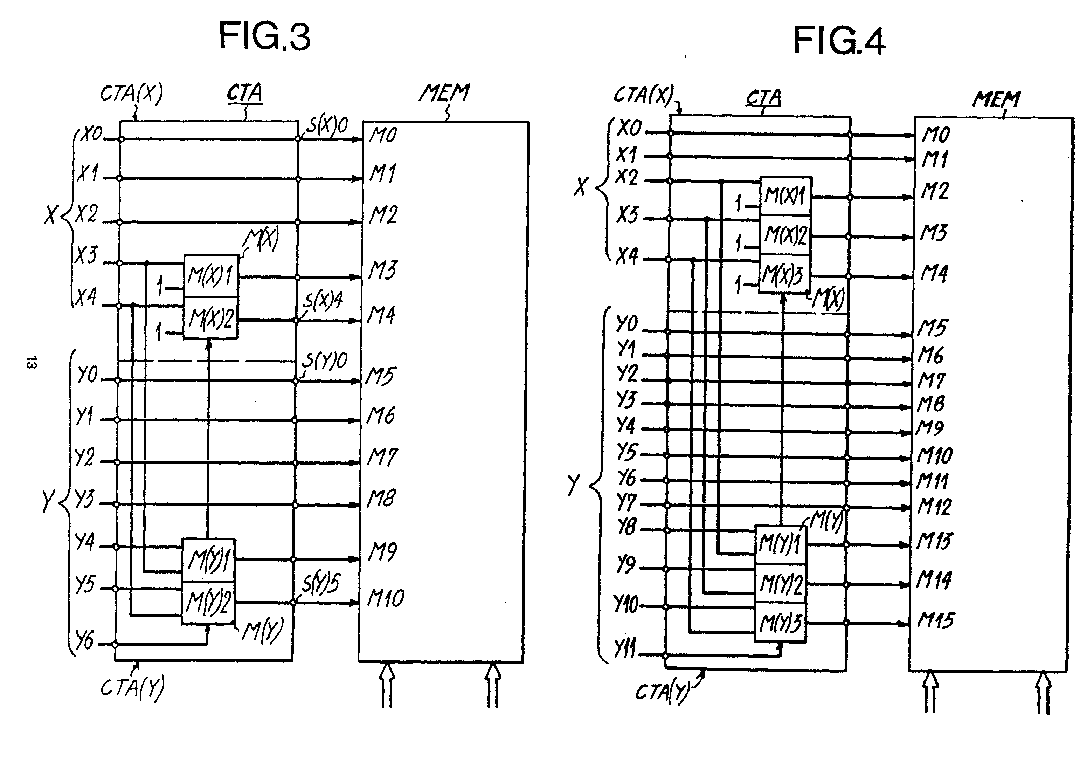

Deux exemples de réalisation vont maintenant être décrits en référence aux fig. 3 et 4.

Le premier exemple correspond à une mémoire d'écran d'affichage alphanumérique de $80\times24$ mots utilisant une mémoire de 2048 mots.

Avec les notations précédentes, on a $p=6$ et $q=4$ ainsi que $A=80$ et $B=24$.

Les relations définissant $r$ sont alors:

$$A' = (2^r-1)\times2^{6+1-r} \geq 80, \text{ et}$$

$$B' = 2^4+2^{4-r} \geq 24$$

La deuxième inéquation impose $2^{4-r} \geq 24-16$, soit $2^{4-r} \geq 8$, donc $R=1$. Il en résulte que $A'=64$. Comme $A'$ n'est pas supérieur à $A$, cette solution ne convient pas.

On réitère l'essai en permutant les deux nombres $A$ et $B$. On prend donc cette fois $p=4$ et $q=6$ avec $A=24$ et $B=80$.

On cherche alors $r$ tel que:

$$A' = (2^4-1)\times2^{4+1-r} \geq 24, \text{ et}$$

$$B' = 2^6+2^{6-r} \geq 80.$$

La deuxième inéquation donne $2^{6-r} \geq 80-64=16$, d'où $r=2$. Il en résulte que $A'=24$, ce qui convient.

La solution est donc $p=4$, $q=6$, $r=2$.

Le schéma de multiplexage est alors le suivant, où les fils multiplexés sont encore marqués par une flèche:

| M10 | M9 | M8 | M7 | M6 | M5 | M4 | M3 | M2 | M1 | M0 |
|-----|-----|-----|-----|-----|-----|-----|-----|-----|-----|-----|
| Y6=0: Y5 | Y4 | Y3 | Y2 | Y1 | Y0 | X4 | X3 | X2 | X1 | X0 |
| Y6=1: X4 | X3 | Y3 | Y2 | Y1 | Y0 | «1» | «1» | X2 | X1 | X0 |
| ↑ | ↑ | | | | | ↑ | ↑ | | | |

On obtient ainsi un circuit mémoire qui fait juste $24\times80$ mots et qui est représenté sur la fig. 3. Il comprend un premier multiplexeur $M(X)$ constitué de deux multiplexeurs $2\rightarrow1$, respectivement $M(X)1$ et $M(X)2$ dont les entrées reçoivent $X3$ et $X4$ d'une part, et deux signaux logiques 1 d'autre part. Il comprend un second multiplexeur $M(Y)$ constitué, lui aussi, de deux multiplexeurs $2\rightarrow1$, respectivement $M(Y)1$ et $M(Y)2$ dont les entrées reçoivent $Y4$, $Y5$ d'une part et $X3$, $X4$ d'autre part. L'élément binaire $Y6$ de plus fort poids les commande tous deux. La mémoire MEM comprend 11 entrées d'adressage $M0$ à $M10$. Le circuit de transcodage CTA possède cinq entrées pour l'adresse $X$, soit $X0$ à $X4$, six entrées pour l'adresse $Y$, soit $Y0$ à $Y5$ plus l'entrée de commande pour $Y6$, et onze sorties $S(X)0$ à $S(X)4$ et $S(Y)0$ à $S(Y)5$.

Le second exemple correspond à une mémoire d'écran d'affichage graphique de 27×2288 mots utilisant une mémoire de 64K mots.

Dans cet exemple, on a p=4 et q=11 ainsi que A=27 et B=2288.

On cherche r tel que:

| | M15 | M14 | M13 | M12 | M11 | M10 | M9 | M8 | M7 | M6 | M5 | M4 | M3 | M2 | M1 | M0 |
|---|---|---|---|---|---|---|---|---|---|---|---|---|---|---|---|---|
| si Y11 = 0 | Y10 | Y9 | Y8 | Y7 | Y6 | Y5 | Y4 | Y3 | Y2 | Y1 | Y0 | X4 | X3 | X2 | X1 | X0 |
| si Y11 = 1 | X4 | X3 | X2 | Y7 | Y6 | Y5 | Y4 | Y3 | Y2 | Y1 | Y0 | «1» | «1» | «1» | X1 | X0 |
| | ↑ | ↑ | ↑ | | | | | | | | | ↑ | ↑ | ↑ | | |

De cette façon, on obtient une mémoire de 28×2304 mots, soit 1792×2304 points. Chaque mot peut comprendre 64 éléments binaires dans le cas de l'application à l'affichage graphique. La fig. 4 représente le circuit obtenu. Le circuit de transcodage d'adresses comprend cinq entrées affectées à X (X0 à X4) et douze entrées affectées à Y (Y0 à Y11). Les multiplexeurs M(X) et M(Y) comprennent chacun trois multiplexeurs 2→1. Le premier multiplexe les éléments X2, X3, X4 avec un même niveau logique «1» et le second les éléments Y8, Y9, Y10 avec X2, X3, X4. La commande du multiplexage s'effectue par Y11.

## Revendications

1. Mémoire destinée à mémoriser A×B mots, où A et B sont des nombres qui vérifient les inégalités:

$$2^p < A < 2^{p+1}$$

$$2^q < B < 2^{q+1}$$

$$2^{p+q} < A \times B < 2^{p+1}$$

où p et q sont des entiers, caractérisée en ce qu'elle comprend p+q+1 entrées d'adressage reliées à un circuit de transcodage d'adresses (CTA) comprenant deux parties:

a) une première partie (CTA)X constituée par:

p+1 entrées (E(X)0...E(X)p) et p+1 sorties (S(X)0...S(X)p), les p+1 entrées recevant p+1 éléments binaires (X0...Xp) définissant un nombre X inférieur à A, ces éléments binaires étant répartis entre un élément de plus faible poids (X0) et un élément de plus fort poids (Xp), les p+1 sorties étant reliées à p+1 premières entrées d'adressage (M0...Mp) de la mémoire (MEM),

p+1−r connexions directes CD(X) entre les p+1−r entrées affectées aux p+1−r éléments binaires de X de plus faible poids et p+1−r sorties,

un premier multiplexeur M(X) possédant un premier groupe (e(X)1) de r entrées recevant des expressions logiques des r éléments binaires (Xp−r+1...Xp) de plus fort poids de X reçus par les r entrées correspondantes, et un second groupe (e(X)2) de r entrées portées à un même niveau logique prédéterminé, ce premier multiplexeur possédant r sorties (s(X) reliées aux r sorties restantes de cette première partie,

$$A' = (2^r - 1) \times 2^{4+1-r} \geq 27, \text{ et}$$

$$B' = 2^{11} + 2^{11-r} \geq 2288.$$

La deuxième inéquation donne r=3, d'où A'=28, solution qui convient. On obtient donc le schéma de multiplexage suivant:

b) une seconde partie (CTA(Y)) constituée par:

q+1 entrées (E(Y)0...E(Y)q) et q sorties (S(Y)0...S(Y)q−1), les q+1 entrées recevant q+1 éléments binaires (Y0...Yq) définissant un nombre Y inférieur à B, ces éléments binaires étant répartis entre un élément de plus faible poids (Y0) et un élément de plus fort poids (Yq), les q sorties étant reliées aux q dernières entrées d'adressage (Mp+1...Mp+q) de la mémoire,

q−r connexions directes (CD(Y)) entre les q−r entrées affectées aux q−r éléments binaires de plus faible poids de Y et q−r sorties,

un second multiplexeur (M(Y)) possédant un premier groupe (e(Y)1) de r entrées recevant des expressions logiques des r éléments binaires de plus fort poids (Yq−r+1...Yq−1) de Y pris après l'élément binaire de Y ayant le plus fort poids (Yq) et un second groupe (e(Y)2) de r entrées reliées au premier groupe de r entrées (e(X)1) du premier multiplexeur (M(X)) de la première partie, ce second multiplexeur possédant r sorties (s(Y)) reliées aux r sorties restantes (S(X)q−r...S(Y)q−1) de cette seconde partie,

chaque multiplexeur possédant en outre une entrée de commande (C(X), C(Y)) qui reçoit l'élément binaire (Yq) de plus fort poids du nombre Y appliqué à l'entrée (E(Y)q) de plus fort poids de la seconde partie, les r entrées d'adressage (Mp−r+1...Mp) de la mémoire qui sont reliées aux sorties du premier multiplexeur (M(X)) recevant ainsi, selon la valeur de l'élément binaire (Yq) de plus fort poids de Y, soit r expressions logiques des r éléments binaires (Xp−r+1...Xp) de plus fort poids de X, soit r niveaux logiques prédéterminés, et les r entrées d'adressage (Mp+q−r+1...Mp+q) de la mémoire qui sont reliées aux sorties du second multiplexeur (M(Y)) recevant de même soit les r éléments binaires de plus fort poids de Y pris après l'élément ayant le plus fort poids (Yq−=r+1...Yq−1), soit les r éléments binaires de plus fort poids de X (Xp−r+1...Xp), dans ce qui précède, r étant un entier vérifiant les relations:

$$(r^r - 1)2^{p+1-r} \geq A$$

$$2^q + 2^{q-r} \geq B.$$

2. Mémoire selon la revendication 1, caractérisée en ce que chaque multiplexeur (M(X), M(Y)) est constitué de r multiplexeurs 2→1.

3. Mémoire selon la revendication 1, caractérisée en ce que lesdites expressions logiques d'éléments binaires sont les éléments binaires eux-mêmes.

4. Mémoire selon la revendication 1, caractérisé en ce qu'elle est apte à traiter 24×80 mots et en ce qu'elle comprend une mémoire à onze entrées d'adressage, et un circuit de transcodage d'adresses comprenant:

– une première partie comprenant cinq entrées, cinq sorties, deux multiplexeurs 2→1,

– une seconde partie à six entrées d'adressage plus une entrée de commande et six sorties, et deux multiplexeurs 2→1.

5. Mémoire selon la revendication 1, caractérisée en ce qu'elle est apte à traiter 27×2288 mots et en ce quelle comprend une mémoire à seize entrées d'adressage et un circuit de transcodage d'adresses comprenant:

– une première partie comprenant cinq entrées, cinq sorties, et trois multiplexeurs 2→1,

une seconde partie comprenant onze entrées d'adressage, plus une douzième de commande, et onze sorties et trois multiplexeurs 2→1.

**Patentansprüche**

1. Speicher zum Speichern von A×B-Wörtern, wobei A und B Zahlen sind, die die Ungleichungen erfüllen:

$$2^p < A < 2^{p+1}$$

$$2^q < B < 2^{q+1}$$

$$2^{p+q} < A \times B < 2^{p+1}$$

mit p und q ganzen Zahlen, dadurch gekennzeichnet, dass der Speicher $p+q+1$ Adresseneingänge aufweist, die mit einer Adressentranscodierschaltung (CTA) verbunden sind, die zwei Teile enthält:
a) einen ersten Teil (CTA)X, der gebildet ist von:

$p+1$ Eingängen $(E(X)0 \ldots E(X)p)$ und $p+1$ Ausgängen $(S(X)0 \ldots S(X)p)$, wobei die $p+1$ Eingänge $p+1$ Binärelemente $(X0 \ldots Xp)$ erhalten, die eine Zahl X kleiner als A angeben, diese Binärelemente zwischen einem Element mit geringstem Gewicht (XO) und einem Element mit grösstem Gewicht (Xp) aufgeteilt sind und die $p+1$ Ausgänge mit den $p+1$ ersten Adressierungseingängen $(M0 \ldots Mp)$ des Speichers (MEM) verbunden sind,

$p+1-r$ direkten Verbindungen CD(X) zwischen den $p+1-r$ Eingängen, die den $p+1-r$ Binärelementen von X mit geringstem Gewicht zugeordnet sind, und $p+1-r$ Ausgängen,

einem ersten Multiplexer (M(X)), der eine erste Gruppe (e(X)1) von r Eingängen, die logische Ausdrücke der r Binärelemente $(Xp-r+1 \ldots Xp)$ mit dem grössten Gewicht von X enthält, die von den r entsprechenden Eingängen erhalten wurden, und eine zweite Gruppe (e(X)2) von r Eingängen aufweist, die auf den gleichen, vorbestimmten, logischen Pegel gebracht sind, wobei der erste Multiplexer r Ausgänge (s(X)) besitzt, die mit den r restlichen Ausgängen dieses ersten Teils verbunden sind,
b) einen zweiten Teil (CTA(Y)), der gebildet ist von:

$q+1$ Eingängen $(E(Y)0 \ldots E(Y)q)$ und q Ausgängen $(S(Y)0 \ldots S(Y)q-1)$, wobei die $q+1$ Eingänge $q+1$ Binärelemente $(Y0 \ldots Yq)$ erhalten, die eine Zahl Y kleiner als B angeben, diese Binärelemente zwischen einem Element mit geringstem Gewicht (Y0) und einem Element mit grösstem Gewicht (Yq) aufgeteilt sind und die q Ausgänge mit den q letzten Adressierungseingängen $(Mp+1 \ldots Mp+q)$ des Speichers verbunden sind, $q-r$ direkten Verbindungen (CD(Y)) zwischen den $q-r$ Eingängen, die den $q-r$ Binärelementen mit geringstem Gewicht von Y zugeordnet sind, und $q-r$ Ausgängen,

einem zweiten Multiplexer (M(Y)), der eine erste Gruppe (e(Y)1) von r Eingängen, die logische Ausdrücke der r Binärelemente mit grösstem Gewicht $(Yq-r+1 \ldots Yq-1)$ von Y erhält, die hinter dem Binärelement von Y mit dem grössten Gewicht (Yq) genommen sind, und eine zweite Gruppe (e(Y)2) von r Eingängen aufweist, die mit der ersten Gruppe von r Eingängen (e(X)1) des ersten Multiplexers (M(X)) des ersten Teils verbunden sind, wobei der zweite Multiplexer r Ausgänge (s(Y)) aufweist, die mit den r übrigen Ausgängen $(S(X)q-r \ldots S(Y)q-1)$ dieses zweiten Teils verbunden sind,

dass jeder Multiplexer ferner einen Steuereingang (C(X), C(Y)) aufweist, der das Binärelement (Yq) mit dem grössten Gewicht der Zahl Y erhält, welches an dem Eingang $(E(Y)q)$ mit dem grössten Gewicht des zweiten Teils anliegt, dass die r Adressierungseingänge $(Mp-r+1 \ldots Mp)$ des Speichers, die mit den Ausgängen des ersten Multiplexers (M(X)) verbunden sind, somit gemäss dem Wert des Binärelementes (Yq) des grössten Gewichts für Y entweder r logische Ausdrücke von r Binärelementen $(Xp-r+1 \ldots Xp)$ von dem höchsten Gewicht von X oder r vorbestimmte logische Pegel erhalten und die r Adressierungseingänge $(Mp+q-r+1 \ldots Mp+q)$ des Speichers, die mit den Ausgängen des zweiten Multiplexers (M(Y)) verbunden sind, erhalten in gleicher Weise entweder die r Binärelemente mit dem höchsten Gewicht von Y, die nach dem Element mit dem grössten Gewicht $(Yq-r+1 \ldots Yq-1)$ genommen sind, oder die r Binärelemente mit höchstem Gewicht von X $(Xp-r+1 \ldots Xp)$, wobei im Vorhergehenden r eine ganze Zahl ist, die die Beziehungen erfüllt:

$$(r^r-1)2^{p+1-r} \geqslant A$$

$$2^q + 2^{q-r} \geqslant B.$$

2. Speicher nach Anspruch 1, dadurch gekennzeichnet, dass jeder Multiplexer (M(X), M(Y)) von r Multiplexern 2→1 gebildet ist.

3. Speicher nach Anspruch 1, dadurch gekennzeichnet, dass die logischen Ausdrücke der Binärelemente die Binärelemente selbst sind.

4. Speicher nach Anspruch 1, dadurch gekennzeichnet, dass er 24×80 Wörter verarbeiten kann und dass er einen Speicher mit 11 Adressierungseingängen und eine Adressentranscodierschaltung umfasst mit:

– einem ersten Teil, der fünf Eingänge, fünf Ausgänge, zwei Multiplexer 2→1 aufweist,

– einem zweiten Teil mit sechs Adressierungseingängen sowie einem Steuereingang und sechs Ausgängen, und zwei Multiplexern 2→1.

5. Speicher nach Anspruch 1, dadurch gekennzeichnet, dass er 27×2288 Wörter verarbeiten känn und dass er einen Speicher mit sechzehn Adressierungseingängen und eine Adressentranscodierschaltung aufweist, die umfasst:

– einen ersten Teil mit fünf Eingängen, fünf Ausgängen und drei Multiplexern 2→1,

– einen zweiten Teil, der elf Adressierungseingänge sowie einen zwölften Steuereingang und elf Ausgänge und drei Multiplexer 2→1 umfasst.

**Claims**

1. Memory intended to store A×B words, where A and B are numbers which verify the inequalities:

$$2^p < A < 2^{p+1}$$

$$2^q < B < 2^{q+1}$$

$$2^{p+q} < A \times B < 2^{p+1}$$

where p and q are integers, characterized in that it includes p+q+1 addressing inputs connected to an address transcoding circuit (CTA) including two sections:

a) a first section (CTA)X formed by:

p+1 inputs (E(X)0...E(X)p) and p+1 outputs (S(X)0...S(X)p), the p+1 inputs receiving p+1 bits (X0...Xp) defining a number X less than A, these bits being distributed between a least significant bit (X0) and a most significant bit (Xp), the p+1 outputs being connected to p+1 first addressing inputs (M0...Mp) of the memory (MEM),

p+1−r direct connections CD(X) between the p+1−r inputs allocated to the p+1−r least significant bits of X and p+1−r outputs

a first multiplexer M(X) having a first group (e(X)1) of r inputs receiving locigal expressions of the r most significant bits (Xp−r+1...Xp) of X received by the r corresponding inputs, and a second group (e(X)2) of r inputs taken to a same predetermined logic level, this first multiplexer having r outputs connected to the r remaining outputs of this first section,

b) a second section (CTA(Y)) formed by:

q+1 inputs (E(Y)0...E(Y)q) and q outputs (S(Y)0...S(Y)q−1), the p+1 inputs receiving q+1 bits (Y0...Yq) defining a number Y less than B, these bits being distributed between a least significant bit (Y0) and a most significant bit (Yq), the q outputs being connected to the last q addressing inputs (Mp+1...Mp+q) of the memory,

q−r direct connections (CD(Y)) between the q−r inputs allocated to the q−r most significant bits of Y and q−r outputs,

a second multiplexer (M(Y)) having a first group (e(Y)1 of r inputs receiving logical expressions of the r most significant bits (Yq−r+1...Yq−1) of Y taken after the bit of Y having the most significance (Yq) and a second group (e(Y)2) of r inputs connected to the first group of r inputs (e(X)1) of the first multiplexer (M(X)) of the first section, this second multiplexer having outputs (s(Y)) connected to the r remaining outputs (S(Y) q−r...S(Y)q−1) of this second section,

each multiplexer also having a control input (C(X), C(Y)) which receives the most significant bit (Yq) of the number Y applied to the most significant input (E(Y)q) of the second section, the r adressing inputs (Mp−r+1...Mp) of the memory which are connected to the outputs of the first multiplexer (M(X)) thus receiving, depending on the value of the most significant bit (Yq) of Y, either r logic expression of the r most significant bits (Xp−r+1...Xp) of X, or r predetermined logic levels and the r addressing inputs (Mp+q−r+1...Mp+q) of the memory which are connected to the outputs of the second multiplexer (M(Y)) similarly receiving either the r most significant bits of Y taken after the most significant bit (Yq=r+1...Yg−1) or the r most significant bits of X (Xp−r+1...Xp), in the above, r being an integer verifying the expressions:

$$(2^r-1)2^{p+1-r} \geqslant A$$

$$2^q+2^{q-r} \geqslant B.$$

2. Memory according to claim 1, characterized in that each multiplexer (M(X), M(Y)) is formed from r 2→1 multiplexers.

3. Memory according to claim 1, characterized in that the said logic expressions of bits are the bits themselves.

4. Memory according to claim 1, characterized in that it is capable of processing 24×80 words and in that it includes a memory with eleven addressing inputs, and an address transcoding circuit including:

a first section including five inputs, five outputs, two 2→1 multiplexers,

a second section with six addressing inputs plus one control input and six outputs, and two 2→1 multiplexers.

5. Memory according to claim 1, characterized in that it is capable of processing 27×2288 words and in that in includes a memory with sixteen addressing inputs and an address transcoding circuit including:

a first section including five inputs, five outputs and three 2→1 multiplexers;

a second section including eleven addressing inputs, plus a twelfth of control input and eleven outputs and three 2→1 multiplexers.

0120721

# FIG.1

FIG.2

# FIG.3

# FIG.4